# EUROPÄISCHE PATENTANMELDUNG

(11) **EP 2 581 752 A2**
(43) Veröffentlichungstag der Anmeldung: **17.04.2013**
(21) Anmeldenummer: 12188139.5
(22) Anmeldetag: 11.10.2012
(51) Int. Cl.: G01R 19/155, G01R 13/40, G01R 31/00, G01R 31/04

(54) **Vorrichtung zum Visualisieren von elektrischen Leitungszuständen**

(30) Priorität: 11.10.2011 DE 102011054394
(71) Anmelder: TKR Spezialwerkzeuge GmbH, 58285 Gevelsberg (DE)
(72) Erfinder: Weyland, Thorsten, 58239 Schwerte (DE)
(74) Vertreter: Kalkoff & Partner

(57) **Zusammenfassung**

Die Erfindung betrifft ein Prüfvorrichtungsmodul 3, 4 zum Visualisieren von elektrischen Leitungszuständen in einem Kraftfahrzeug. Um eine auf eine bisher nicht zu bestimmende Leitungsanzahl ausgerichtete Prüfungsvorrichtung 1 bereitzustellen, die eine Gesamtübersicht über die Leitungszustände aller angeschlossenen Leitungen ermöglicht, ist ein Prüfvorrichtungsmodul 3, 4 mit einer zum Anschluss an ein elektrisches Leitungssystem des Kraftfahrzeugs ausgebildeten Steckereinheit 10, 11 mit einer Mehrzahl von Kontaktelementen, einer eine Mehrzahl von Kontrolleinheiten 6 aufweisenden Anzeigetafel 5, wobei jeweils eine Kontrolleinheit 6 ein optisches Signalelement 7 und ein Anschlusselement 8 aufweist und mit jeweils einem Kontaktelement elektrisch kontaktiert ist und einem mit dem Anschlusselement 8 elektrisch kontaktierbaren Basisanschluss 9 vorgesehen.

## Beschreibung

Die Erfindung betrifft ein Prüfvorrichtungsmodul zum Visualisieren von elektrischen Leitungszuständen in Kraftfahrzeugen gemäß Anspruch 1 und eine Prüfungsvorrichtung gemäß Anspruch 10.

Verkabelungen in Kraftfahrzeugen, insbesondere in Pkw, sind zur besseren Handhabung oftmals gebündelt und mit einem gemeinsamen Steckverbinder ausgestattet. Um die einzelnen Leitungen zu überprüfen, kann der Steckverbinder über ein Y-Kabel an eine Prüfungsvorrichtung angeschlossen werden.

Die bekannten Prüfungsvorrichtungen weisen derzeit bis zu 105 Anschlusseinheiten auf, wobei jede Anschlusseinheit mit einer Leitung des Steckverbinders elektrisch kontaktiert ist. Über ein mit der Prüfungsvorrichtung zu verbindendes Messgerät (analog oder digital) kann jede Leitung einzeln auf ihren elektrischen Leitungszustand, d. h. beispielsweise auf die an ihr anliegende Spannung, Stromstärke oder ihren Widerstand überprüft werden.

In einer Vielzahl der prüfungsrelevanten Fälle ist jedoch bereits die Überprüfung dahingehend, ob eine Spannung anliegt, ausreichend, wobei die Stärke der Spannung nachrangig ist. Diese Spannungsüberprüfung kann mit den bekannten Prüfungsvorrichtungen jedoch nur einzeln und nur unter Verwendung zusätzlicher Messgeräte erfolgen. Sie ist somit sehr zeitaufwendig.

Auch ist bei den bekannten Prüfungsvorrichtungen nicht ersichtlich, welche der 105 Anschlusseinheiten an eine Kraftfahrzeugleitung angeschlossen ist, da abhängig vom Fahrzeug nicht alle im Stecker der Prüfungsvorrichtung vorhandenen Kontakte mit einer Kraftfahrzeugleitung elektrisch kontaktiert sein müssen.

Ferner werden die Leitungssysteme in Kraftfahrzeugen immer komplexer, so dass Prüfungsvorrichtungen zum Überprüfen von maximal 105 Kraftfahrzeugleitungen in einer Steckverbindung nicht mehr ausreichend sind. Die bekannten Prüfungsvorrichtungen sind jedoch für sich abgeschlossene Systeme, sodass eine einfache Erweiterung nicht möglich ist. Die Konstruktion neuer, für mehr Leitungen ausgebildeter Prüfungsvorrichtungen ist kostspielig. Aufgrund dessen, dass nicht absehbar ist, wie viele Leitungen zukünftig in einer Steckerverbindung zusammengefasst werden, ist eine Weiterentwicklung der Prüfungsvorrichtungen somit wirtschaftlich risikoreich.

Der Erfindung liegt somit die Aufgabe zugrunde, eine auf eine bisher nicht zu bestimmende Leitungsanzahl ausgerichtete Prüfungsvorrichtung bereitzustellen, die eine einfache Gesamtübersicht über die Leitungszustände sämtlicher angeschlossener Kraftfahrzeugleitungen ermöglicht.

Die Aufgabe wird gelöst durch ein Prüfungsvorrichtungsmodul gemäß Anspruch 1 und eine Prüfungsvorrichtung gemäß Anspruch 10. Vorteilhafte Weiterbildungen sind in den abhängigen Ansprüchen angegeben.

Das erfindungsgemäße Prüfvorrichtungsmodul zum Visualisieren von elektrischen Leitungszuständen in einem Kraftfahrzeug weist eine zum Anschluss an ein elektrisches Leitungssystem des Kraftfahrzeugs ausgebildete Steckereinheit mit einer Mehrzahl von Kontaktelementen und eine eine Mehrzahl von Kontrolleinheiten aufweisende Anzeigetafel auf, wobei jeweils eine Kontrolleinheit ein optisches Signalelement und ein Anschlusselement aufweist und mit jeweils einem Kontaktelement elektrisch kontaktiert ist. Ferner ist ein mit dem Anschlusselement elektrisch kontaktierbarer Basisanschluss vorgesehen.

Das erfindungsgemäße Prüfvorrichtungsmodul ermöglicht mittels der in der Anzeigetafel angeordneten optischen Signalelemente das sofortige Erfassen sämtlicher Leitungszustände der angeschlossenen Kraftfahrzeugleitungen. Hierdurch entfällt in vorteilhafter Weise ein zeitaufwendiges einzelnes Überprüfen jeder angeschlossenen Kraftfahrzeugleitung. Zusätzlich ermöglichen die Anschlusseinheit und der Basisanschluss den Anschluss externer Messgeräte, wodurch beispielsweise eine exakte Messung der an einer Kraftfahrzeugleitung anliegenden Spannung möglich ist.

Ein Prüfvorrichtungsmodul ist in alleiniger Benutzung als Prüfungsgerät verwendbar. Es ist jedoch auch mit weiteren Prüfvorrichtungsmodulen zu einer erfinderischen Prüfungsvorrichtung koppelbar. Die Modulbauweise ermöglicht in vorteilhafter Weise eine unkomplizierte Erweiterung der Prüfungsvorrichtung, wodurch besonders flexibel auf zukünftige zu überprüfende Leitungsanzahlen in Kraftfahrzeugen reagiert werden kann.

Unter dem Visualisieren ist die Möglichkeit des optischen Erfassens durch eine das Prüfvorrichtungsmodul verwendete Person zu verstehen. Unter den hierfür notwendigen optischen Signalelementen werden sämtliche Leuchtmittel, bspw. Glühbirnen oder bevorzugt LED-basierte Signalelemente verstanden. Diese können dazu ausgebildet sein, ein einfarbiges oder mehrfarbiges Signal anzuzeigen. Auch können diese beispielsweise zur Wiedergabe von Dauersignalen oder blinkenden Signalen ausgelegt sein. Sowohl die Signalfarben als auch der Signalrhythmus kann unterschiedliche Bedeutungen aufweisen.

Ein optisches Signalelement und eine Anschlusseinheit bilden eine Kontrolleinheit, die dazu ausgelegt ist, eine Kraftfahrzeugleitung zu überprüfen. Die Anschlusseinheit kann als leicht verbindbarer, gegebenenfalls (zerstörungsfrei) lösbarer Anschluss ausgebildet sein. Zum Beispiel kann die Anschlusseinheit als Klemm-, Rast-, Steck- und/oder Schraubanschluss ausgebildet sein. Auch nicht lösbare Anschlüsse, wie beispielsweise verlötete Anschlüsse sind denkbar. Insbesondere wird die Anschlusseinheit jedoch als Stecker oder Buchse, vorteilhaft als eine zu einem standardisierten Stecker korrespondierende Buchse, ausgebildet. Es ist insbesondere eine zur elektrischen Kontaktierung übliche Anschlussvorrichtung verwendbar.

Jede Kontrolleinheit ist mit einem Kontaktelement in der Steckereinheit elektrisch kontaktiert, wobei jedes Kontaktelement in der Steckereinheit mit einer Leitung im Kraftfahrzeug elektrisch kontaktierbar ist. Somit ist über eine Kontrolleinheit jeweils eine Kraftfahrzeugleitung überprüfbar.

Unter einer Mehrzahl werden mindestens zwei Kontrolleinheiten verstanden. Bevorzugt sind zwischen 10 und 200, besonders bevorzugt zwischen 20 und 150, vorzugsweise zwischen 30 und 100, vorteilhaft 33 und besonders vorteilhaft eine Vielzahl von 33 Kontrolleinheiten in der Anzeigetafel angeordnet. Die Anzeigetafel ist dazu ausgelegt die Kontrolleinheiten, bzw. zumindest die Signalelemente, optisch sichtbar aufzunehmen.

Die Steckereinheit ist ein Bestandteil einer Steckverbindung und kann beispielsweise als einer von Steckverbinder (z.B. ein Stecker) oder Steckverbinderaufnahme (z.B. eine Buchse) ausgebildet sein. Zur Kontrolle von elektrischen Leitungssystemen in Kraftfahrzeugen sind beispielsweise sogenannte Y-Kabel verwendbar, die mit der Steckverbindung in Kraftfahrzeugen und mit der Steckereinheit am Prüfvorrichtungsmodul elektrisch kontaktiert werden. Elektrisch kontaktiert bedeutet, dass eine elektrisch leitende Verbindung hergestellt ist oder werden kann. Das Y-Kabel ermöglicht dabei die Durchführung im Betriebszustand des zu überprüfenden Kraftfahrzeugs.

Unter einer Mehrzahl von Kontaktelementen werden mindestens zwei Kontaktelemente verstanden. Vorteilhafterweise weist die Steckereinheit für jede Kontrolleinheit mindestens ein mit der Kontrolleinheit elektrisch kontaktiertes Kontaktelement auf. Auch können weitere Kontaktelemente für beispielsweise einen zentralen Masseanschluss ausgebildet sein.

Der Basisanschluss im Prüfvorrichtungsmodul ist bspw. in seiner Form und Größe sowie Kontaktierbarkeit entsprechend den Anschlusselementen ausbildbar. Vorteilhafterweise ist auch dieser als Stecker oder Buchse ausgebildet. Vorteilhafterweise ist der Basisanschluss als Masseanschluss und somit elektrisch kontaktierbar mit der Kraftfahrzeugmasse ausgebildet.

Gemäß einer Weiterbildung der Erfindung ist das Prüfvorrichtungsmodul gekennzeichnet durch eine zur Funktionsüberprüfung der Signalelemente ausgebildete Testvorrichtung, die mit den Signalelementen elektrisch kontaktiert ist und ein zur Aktivierung und/oder Deaktivierung ausgebildetes Schaltelement aufweist und derart ausgebildet ist, dass die Signalelemente bei aktivierter Testvorrichtung ein optisches Signal anzeigen.

Das Prüfvorrichtungsmodul ist über die Steckereinheit mit den elektrischen Leitungssystemen von unterschiedlichen Kraftfahrzeugen verbindbar. D. h., eine Kontrolleinheit ist dann über ein Kontaktelement der Steckereinheit mit einer Kraftfahrzeugleitung elektrisch kontaktiert. Hierbei ist es möglich, dass abhängig vom Kraftfahrzeug / Kraftfahrzeugtyp, nicht jedes Kontaktelement der Steckereinheit mit einer Leitung im Kraftfahrzeug kontaktiert ist. Dies kann, sofern beispielsweise ein optisches Signalelement kein optisches Signal anzeigt, bei einer visuellen Überprüfung der elektrischen Leitungszustände zu Fehlinterpretationen über den jeweiligen Leitungszustand führen.

Die Testvorrichtung ermöglicht in vorteilhafter Weise die Überprüfung der optischen Signalelemente auf ihre Funktion. Die Testvorrichtung ist derart mit den optischen Signalelementen kontaktiert, dass bei Aktivierung der Testvorrichtung alle Signalelemente ein optisches Signal wiedergeben. Die Signalelemente, die bei aktivierter Testvorrichtung kein optisches Signal wiedergeben, d. h. die beispielsweise nicht leuchten, sind nicht funktionsfähig, bspw. beschädigt. Die Testvorrichtung ermöglicht es somit, in vorteilhafter Weise Fehlinterpretationen beim Überprüfen von elektrischen Leitungszuständen zu verhindern.

Die Testvorrichtung kann eine eigene, im Prüfvorrichtungsmodul integrierte Stromquelle (beispielsweise eine Batterie) aufweisen. Auch ist es möglich, eine externe Stromquelle, bspw. über die Steckereinheit mit der Testvorrichtung zu verbinden, so dass beim Aktivieren der Testvorrichtung die optischen Signalelemente durch die externe Stromquelle angesteuert werden können. Das Schaltelement der Testvorrichtung ist beispielsweise als üblicher Druckknopf, Schalter oder Hebel ausgebildet.

Das Prüfvorrichtungsmodul/ die Prüfungsvorrichtung ist dazu ausgelegt, elektrische Leitungen von Kraftfahrzeugen unterschiedlicher Typen / Hersteller zu überprüfen. Hierbei muss nicht gewährleistet sein, dass alle Kontaktelemente der Steckereinheit mit einem Leitungssystem im Kraftfahrzeug verbunden sind. Um bei der Prüfung der elektrischen Leitungszustände die nicht mit einer Leitung verbundenen Kontrolleinheiten zu kennzeichnen, ist gemäß einer Weiterbildung der Erfindung vorgesehen, dass die Anzeigetafel des Prüfvorrichtungsmoduls zur Aufnahme einer kraftfahrzeugspezifischen, die prüfungsrelevanten Signalelemente kennzeichnenden Schablone ausgebildet ist.

Die Anzeigetafel und die Schablone sind dabei derart aufeinander abgestimmt, dass die Schablone lagegesichert, insbesondere im Werkstattbetrieb lagestabil an/über der Anzeigetafel anordbar ist.

Die Schablone/Anzeigetafel kann beispielsweise derart ausgebildet sein, dass sie auf das Prüfvorrichtungsmodul/ Prüfungsvorrichtung aufgesetzt, an diesem anbringbar, mit diesem verbindbar und/oder in eine vorhandene Einrichtung einschiebbar ist. Insbesondere sind Steck-, Klemm-, Einschub-, Haft- oder Magnetverbindungen möglich.

Die Schablone ermöglicht somit eine Kennzeichnung der oder der nicht mit einer Leitung verbundenen Signalelemente/Kontrolleinheiten. Dies kann beispielsweise durch Abdecken oder Markieren der jeweiligen Signalelemente /Kontrolleinheiten erfolgen, wodurch ein besonders leichtes Erfassen und Benutzen der relevanten Signal-/ Anschlusselemente im Werkstattbetrieb möglich ist.

Nach einer Weiterbildung der Erfindung ist vorgesehen, dass das Prüfvorrichtungsmodul eine mit dem Basisanschluss und dem Anschlusselement elektrisch kontaktierbare Messvorrichtung aufweist, die insbesondere dazu ausgebildet ist, eine zwischen Basiselement und Anschlusselement anliegende Spannung zu messen. Hierfür können das Basiselement mit der Fahrzeugmasse und das Anschlusselement mit der zu prüfenden Kraftfahrzeugleitung elektrisch kontaktiert sein.

Bei der Messvorrichtung kann es sich um ein bekanntes analoges oder digitales Messinstrument handeln. Die durchführbaren Messungen sind nicht auf Spannungsmessungen beschränkt. Es können sämtliche Zustände, wie beispielsweise Stromstärke oder Widerstand ermittelt werden. Hierfür kann gegebenenfalls ein entsprechendes Y-Kabel zum elektrischen Kontaktieren des Prüfvorrichtungsmoduls mit dem Kraftfahrzeugleitungssystem verwendet werden, bzw. eine entsprechende elektrische Kontaktierung des Basiselements und Anschlusselements erfolgen.

Die Messvorrichtung kann separat ausgebildet sein und beispielsweise über Kabel und entsprechend zum Basisanschluss und Anschlusselement korrespondierende Verbindungsmittel, wie beispielsweise Buchsen und Stecker ausgestattet sein. Die Messvorrichtung kann auch am oder im Prüfvorrichtungsmodul/ Prüfungsvorrichtung, gegebenenfalls lösbar, angeordnet sein. Insbesondere ist die Messvorrichtung im Prüfvorrichtungsmodul/ in der Prüfungsvorrichtung integriert. Hierbei ist es auch möglich, die Messvorrichtung fest, d. h. nicht lösbar, mit dem Basisanschluss und/oder dem Anschlusselement zu verbinden. Vorteilhaft ist die Messvorrichtung derart ausgebildet, dass eine Anzeigevorrichtung der Messvorrichtung im sichtbaren Bereich der Anzeigetafel integriert ist.

Besonders bevorzugt ist die Messvorrichtung an/in einem zum Prüfvorrichtungsmodul gehörenden Prüfvorrichtungsgehäuse angeordnet. Ein Prüfvorrichtungsgehäuse ermöglicht eine besonders kompakte Bauart, die insbesondere in der Werkstattumgebung einfach zu handhaben ist und besonders stoß-/bruchsicher und sicher vor Beschädigungen ausführbar ist. Vorteilhaft besteht das Gehäuse aus einem stoßfesten/bruchsicheren Kunststoffmaterial oder Verbundmaterial und weist elastische Kantenschutzvorrichtungen auf.

Das Prüfvorrichtungsgehäuse weist gemäß einer besonderen Ausführungsform Aufnahmemittel zur lagesicheren Anordnung der Schablone auf. Die Aufnahmemittel können insbesondere entsprechend der vorbeschriebenen Verbindungsmittel zum Verbinden der Schablone mit der Anzeigetafel ausgebildet. Besonders bevorzugt ist das Aufnahmemittel durch eine Magnethalterung gebildet. Diese ermöglicht zusätzlich zur besonders lagestabilen Positionierung einen einfachen Austausch der Kraftfahrzeug-spezifischen Schablone.

Nach einer Weiterbildung der Erfindung weist das Prüfvorrichtungsmodul eine Verbindungsvorrichtung zum Anschluss eines weiteren Prüfvorrichtungsmoduls auf.

Die Verbindungsvorrichtung ist zum mechanischen Verbinden der Prüfvorrichtungsmodule ausgelegt. Ein Prüfvorrichtungsmodul kann auch mehrere Verbindungsvorrichtungen zum Verbinden mehrerer Prüfvorrichtungsmodule aufweisen. Miteinander verbundene Prüfvorrichtungsmodule können auch eine gemeinsame Anzeigetafel und/oder ein gemeinsames Prüfvorrichtungsgehäuse aufweisen. Auch sind kraftfahrzeugspezifische Schablonen, die mehrere Prüfvorrichtungsmodule umfassen, möglich.

Zusätzlich zur mechanischen Verbindung ist auch eine elektrische Kontaktierung der miteinander verbundenen Prüfvorrichtungsmodule möglich. Somit ist bspw. auch eine gemeinsam über ein Schaltelement bedienbare Testvorrichtung ausbildbar.

Gemäß einer Weiterbildung der Erfindung ist vorgesehen, dass der Basisanschluss derart ausgebildet ist und mit der Verbindungsvorrichtung gekoppelt ist, dass das weitere Prüfvorrichtungsmodul über den Basisanschluss kontaktierbar ist. Ein solcher "zentraler" Basisanschluss ermöglicht insbesondere im Werkstattbetrieb eine besonders einfache Handhabung der verbundenen Prüfvorrichtungsmodule bei der Verwendung zusätzlich anzuschließender Messgeräte.

Es können somit in vorteilhafter Weise verschiedenste Leitungssysteme innerhalb eines Kraftfahrzeuges und/oder unterschiedlicher Kraftfahrzeugtypen/ Kraftfahrzeughersteller durch miteinander verbundene und elektrisch kontaktierte Prüfvorrichtungsmodule besonders einfach getestet werden. Die Modulverbindung ermöglicht somit auch, dass eine besonders hohe Anzahl von miteinander in einer Steckverbindung gebündelten Kraftfahrzeugleitungen mit einer Prüfungsvorrichtung (miteinander verbundene Prüfvorrichtungsmodule) überprüfbar sind.

Weiter wird die der Erfindung zugrundeliegende Aufgabe gelöst durch eine Prüfungsvorrichtung mit einer Mehrzahl von miteinander gekoppelten Prüfvorrichtungsmodulen nach Anspruch 1. Die erfinderische Prüfungsvorrichtung ermöglicht die visuelle Überprüfung von allen in der Steckverbindung zusammengefassten Kraftfahrzeugleitungen.

Unter einer Mehrzahl werden mindestens zwei Prüfvorrichtungsmodule verstanden, wobei die Prüfungsvorrichtung beliebig und jederzeit erweiterbar ist. Die Prüfvorrichtungsmodule sind entsprechend der vorhergehenden Beschreibung sowohl miteinander mechanisch verbindbar als auch elektrisch kontaktierbar.

Die Prüfungsvorrichtungsmodule sind besonders bevorzugt in einem gemeinsamen Prüfungsvorrichtungsgehäuse angeordnet. Das Gehäuse kann entsprechend dem vorbeschriebenen Prüfvorrichtungsgehäuse ausgebildet sein und ermöglicht somit eine besonders kompakte Bauform mehrerer verbundener Prüfvorrichtungsmodule zu einer Prüfungsvorrichtung.

Besonders bevorzugt ist an dem Basisanschluss und dem Anschlusselement eine elektrisch kontaktierbare Messvorrichtung angeschlossen, die insbesondere im oder am Prüfungsvorrichtungsgehäuse angeordnet ist und die dazu ausgebildet ist, eine zwischen dem Basiselement und dem Anschlusselement anliegende elektrische Spannung zu messen.

Die Bestandteile der Prüfungsvorrichtung können entsprechend der vorbeschriebenen Ausführungsformen des Prüfvorrichtungsmoduls ausgeführt sein.

Im Folgenden wird ein Ausführungsbeispiel der Erfindung anhand einer schematischen Zeichnung näher erläutert. Es zeigt:

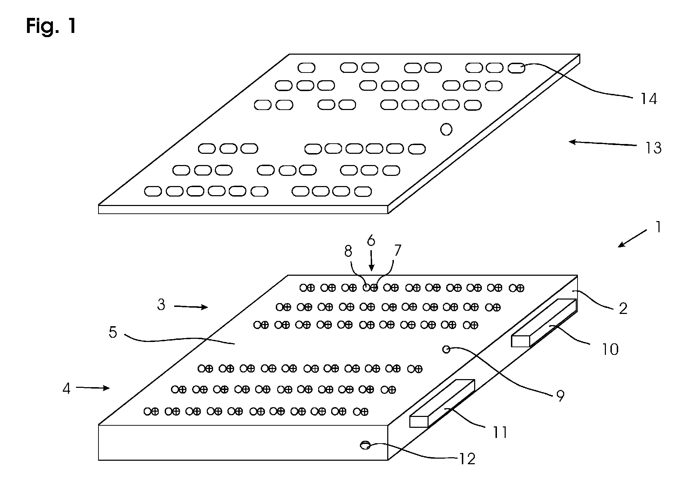

Fig. 1 eine schematische Ansicht einer Ausführungsform einer erfinderischen Prüfungsvorrichtung mit Kfz-spezifischer Schablone.

Fig. 1 zeigt eine Prüfungsvorrichtung 1 mit zwei in einem Prüfungsvorrichtungsgehäuse 2 angeordneten Prüfvorrichtungsmodulen 3, 4. In jedem Prüfvorrichtungsmodul 3, 4 sind jeweils 33 Kontrolleinheiten 6 bestehend aus jeweils einem als LED 7 ausgebildeten optischen Signalelement und einem als Buchse 8 ausgebildeten Anschlusselement angeordnet.

Die Anordnung der Kontrolleinheiten 6 erfolgt in einer für beide Prüfvorrichtungsmodule 3,4 gemeinsam ausgebildeten Anzeigetafel 5. Diese ermöglicht ein besonders einfaches und schnelles optisches Erfassen sämtlicher LED 7 und einen einfachen Zugang zu allen Buchsen 8. Die Anzeigetafel 5 ist Bestandteil des Prüfungsvorrichtungsgehäuses 2.

Jedes Prüfvorrichtungsmodul 3, 4 weist jeweils eine ihr zugeordnete Steckereinheit 10, 11 mit Kontaktelementen (hier nicht dargestellt) auf, wobei für jede Kontrolleinheit 6 ein Kontaktelement in der Steckereinheit 10, 11 angeordnet und mit diesem elektrisch kontaktiert ist. Die Steckereinheit 10, 11 ist am Prüfungsvorrichtungsgehäuse 2 angeordnet.

Ferner weist die Prüfungsvorrichtung 1 einen "zentralen" Basisanschluss 9 auf, der als gemeinsamer Masseanschluss für alle Prüfvorrichtungsmodule 3,4 ausgebildet und über die Steckereinheiten 10 mit der Fahrzeugmasse elektrisch kontaktiert ist.

Zusätzlich ist im Prüfungsvorrichtungsgehäuse 2 eine für beide Prüfvorrichtungsmodule 3, 4 gemeinsame Testvorrichtung (hier nicht dargestellt) angeordnet. Die Testvorrichtung weist einen Druckknopf 12 zum Aktivieren bzw. Deaktivieren der Testvorrichtung auf. Die Testvorrichtung ist über eine externe, an den Steckereinheiten 10, 11 anschließbare Stromquelle (hier nicht dargestellt) mit Strom versorgbar. Die Testvorrichtung ist derart ausgebildet, dass die LED 7 bei angeschlossener Stromquelle im aktivierten Zustand leuchten. Alternativ kann die Testvorrichtung auch eine in der Prüfungsvorrichtung 1 integrierte Stromquelle, bspw. eine Batterie aufweisen.

Weiter zeigt die Figur 1 eine kraftfahrzeugspezifische Schablone 13, die zum Aufsetzen auf die Prüfungsvorrichtung 1 ausgelegt ist. Die Schablone 13 kann mittels einer Magnethalterung (hier nicht dargestellt) lagestabil an der Prüfungsvorrichtung 1 positioniert werden. Die Schablone 13 weist ovale Aussparungen 14 auf, die im aufgesetzten Zustand einen freien Zugang zu den Kraftfahrzeug-spezifisch angeschlossenen Kontrolleinheiten 6 ermöglicht. Die Kontrolleinheiten 6 die nicht mit dem Kraftfahrzeugleitungssystem verbunden sind, werden von der Schablone 13 abgedeckt.

Bei der Verwendung der Prüfungsvorrichtung 1 (alternativ eines Prüfvorrichtungsmoduls) wird zum Ermitteln der anliegenden Spannung in den Kraftfahrzeugleitungen zuerst die Testvorrichtung aktiviert, um die Funktionsfähigkeit der LED 7 zu überprüfen. Bei aktivierter Testvorrichtung werden nicht leuchtende LED 7 ausgetauscht. Anschließend wird ein Y-Kabel (hier nicht dargestellt) mit einem ersten und einem zweiten Ende zwischen die Steckverbindung im Kraftfahrzeug eingesteckt. Das dritte Ende des Y-Kabels weist zwei jeweils zu einer Steckereinheit 10, 11 korrespondierende Steckerverbinder auf, die jeweils in eine Steckereinheit 10, 11 der Prüfungsvorrichtung 1 eingeführt werden.

Durch die auf die Prüfungsvorrichtung 1 aufgesetzte kraftfahrzeugspezifische Schablone 13 werden alle nicht mit dem Kraftfahrzeugleitungssystem verbundenen Kontrolleinheiten 6 abgedeckt. Alle über das Y-Kabel an das Kraftfahrzeugleitungssystem angeschlossenen LED 7 leuchten, sofern eine Spannung an der jeweiligen Kraftfahrzeugleitung anliegt. Bei allen nicht abgedeckten Kontrolleinheiten 6, bei denen die LED 7 nicht leuchtet, liegt keine Spannung an. Zum Ermitteln der individuellen Leitungsspannung kann ein externes Spannungsmessegerät mit dem Basisanschluss 9 und der jeweiligen Anschlusseinheit 8 elektrisch kontaktiert werden. Der Basisanschluss 9 und die Anschlusseinheit 8 sind jeweils als Buchse ausgebildet.

## Patentansprüche

1. Prüfvorrichtungsmodul zum Visualisieren von elektrischen Leitungszuständen in einem Kraftfahrzeug, mit
- einer zum Anschluss an ein elektrisches Leitungssystem des Kraftfahrzeugs ausgebildeten Steckereinheit (10, 11) mit einer Mehrzahl von Kontaktelementen,
- einer eine Mehrzahl von Kontrolleinheiten (6) aufweisenden Anzeigetafel (5), wobei jeweils eine Kontrolleinheit (6) ein optisches Signalelement (7) und ein Anschlusselement (8) aufweist und mit jeweils einem Kontaktelement elektrisch kontaktiert ist und
- einem mit dem Anschlusselement (8) elektrisch kontaktierbaren Basisanschluss (9).

2. Prüfvorrichtungsmodul nach Anspruch 1, **gekennzeichnet durch**
- eine zur Funktionsüberprüfung der Signalelemente (7) ausgebildete Testvorrichtung, die
- mit den Signalelementen (7) elektrisch kontaktiert ist und
- ein zur Aktivierung und/oder Deaktivierung ausgebildetes Schaltelement (12) aufweist und
- derart ausgebildet ist, dass die Signalelemente (7) bei aktivierter Testvorrichtung ein optisches Signal anzeigen.

3. Prüfvorrichtungsmodul nach einem der vorhergehenden Ansprüche, **dadurch gekennzeichnet, dass** die Anzeigetafel (5) zur Aufnahme einer Kraftfahrzeug-spezifischen, die prüfungsrelevanten Signalelemente (7) kennzeichnenden Schablone (13) ausgebildet ist.

4. Prüfvorrichtungsmodul nach einem der vorhergehenden Ansprüche, **gekennzeichnet durch** eine mit dem Basisanschluss (9) und dem Anschlusselement (8) elektrisch kontaktierbare Messvorrichtung, die insbesondere dazu ausgebildet ist, eine zwischen dem Basiselement (9) und dem Anschlusselement (8) anliegende elektrische Spannung zu messen.

5. Prüfvorrichtungsmodul nach einem der vorhergehenden Ansprüche, **gekennzeichnet, durch** ein Prüfungsvorrichtungsgehäuse (2) und/oder eine am/im Prüfungsvorrichtungsgehäuse (2) angeordnete Messvorrichtung.

6. Prüfvorrichtungsmodul nach Anspruch 5, **dadurch gekennzeichnet, dass** das Prüfungsvorrichtungsgehäuse (2) Aufnahmemittel zur lagesicheren Anordnung der Schablone (13) aufweist.

7. Prüfvorrichtungsmodul nach Anspruch 6, **dadurch gekennzeichnet, dass** das Aufnahmemittel durch eine Magnethalterung gebildet ist.

8. Prüfvorrichtungsmodul nach einem der vorhergehenden Ansprüche, **gekennzeichnet durch** eine Verbindungsvorrichtung zum Anschluss eines weiteren Prüfvorrichtungsmodul (3, 4).

9. Prüfvorrichtungsmodul nach Anspruch 8, **dadurch gekennzeichnet, dass** der Basisanschluss (9) derart ausgebildet ist und mit der Verbindungsvorrichtung gekoppelt ist, dass das weitere Prüfvorrichtungsmodul (3, 4) über den Basisanschluss kontaktierbar ist.

10. Prüfungsvorrichtung mit einer Mehrzahl von miteinander gekoppelten Prüfvorrichtungsmodulen nach Anspruch 1.

11. Prüfungsvorrichtung nach Anspruch 10, **dadurch gekennzeichnet, dass** die Mehrzahl von Prüfungsvorrichtungsmodulen (3, 4) in einem Prüfungsvorrichtungsgehäuse (2) angeordnet sind.

12. Prüfungsvorrichtung nach Anspruch 10 oder Anspruch 11, **gekennzeichnet durch** eine mit dem Basisanschluss (9) und dem Anschlusselement (8) elektrisch kontaktierte Messvorrichtung, die insbesondere in oder an einem Prüfungsvorrichtungsgehäuse (2) angeordnet ist und die insbesondere dazu ausgebildet ist, eine zwischen dem Basiselement (9) und dem Anschlusselement (8) anliegende elektrische Spannung zu messen.
